# EUROPEAN PATENT APPLICATION

(11) **EP 3 525 114 A1**
(43) Date of publication of application: **14.08.2019**
(21) Application number: 16918336.5
(22) Date of filing: 07.10.2016
(51) Int. Cl.: G06F 17/50, G06F 11/36

(54) **DESIGN VERIFICATION APPARATUS**

(71) Applicant: Hitachi, Ltd., Tokyo 100-8280 (JP)
(72) Inventor: MATSUBARA, Masahiro, Tokyo 100-8280 (JP)
(74) Representative: MERH-IP Matias Erny Reichl Hoffmann Patentanwälte PartG mbB
(86) International application number: PCT/JP2016/080016
(87) International publication number: WO 2018/066140

(57) **Abstract**

The purpose of the present invention is to provide a technique that facilitates an automatic inspection as to whether design specifications comply with required specifications even when the required specifications and the design specifications are represented by different notations. A design verification apparatus according to the present invention inspects whether the design specifications comply with the required specifications by using a logical expression in which symbols correspond to each other between the required specifications and the design specifications.

## Description

### Technical Field

The present invention relates to a technique of verifying consistency between required specifications and design specifications.

### Background Art

Required specifications are defined in an initial stage of system development. A system, hardware, and software are designed based on the required specifications. A design result is required to satisfy the required specifications.

The following PTL 1 discloses a technique of verifying a design of an interlocking device which implements a railway security function. In PTL 1, required specifications and design specifications are converted into formal language descriptions and equivalency of these two formal language descriptions is formally verified. It is determined that the design is correct when these two formal language descriptions are equivalent to each other and it is determined that there is an error in the design when these two formal language descriptions are not equivalent to each other, and a result of the determination is output.

The following PTL 2 discloses a technique of verifying protective logic for protecting safety of a plant. In PTL 2, whether or not design specifications described by using algebraic specifications and is designed according to required specifications comply with the required specifications is verified.

It is also important that the required specifications are accurately and sufficiently described when verifying whether or not the design complies with the required specifications. In the following PTL 3, required specifications are modeled in a tree form in which a superior requirement (for example, a viewpoint of functions of a system) branches into inferior requirements (for example, requirements related to functions of hardware or software) and the respective requirements are described by using propositional logic, such that the requirements are clearly represented and completeness of the inferior requirements relative to the superior requirements is automatically verified. As described above, representing requirements in a tree form is effective for completely describing requirements for a system.

### Citation List

### Patent Literature

PTL 1: JP H10-16776 A
PTL 2: JP H6-274562 A
PTL 3: JP 2014-174730 A

### Summary of Invention

### Technical Problem

Required specifications and design specifications are each represented by a notation suitable therefor, and thus are represented by different notations in many cases. For example, a behavior is represented by one symbol in the requirement specifications, whereas a state is represented by one variable in the design specifications and a behavior is represented as a procedure in some cases. In this case, it is difficult to automatically associate the behaviors with each other. For example, when a symbol in one requirement and a symbol in a design cannot be associated with each other, a logical expression of the requirement cannot be used as an inspection expression for the design. In addition, the same objects/behaviors are expressed by different symbols between requirement specifications and design specifications in a number of cases.

The present invention has been made in view of the problems described above, and an object of the present invention is to provide a technique that facilitates an automatic inspection as to whether or not design specifications comply with required specifications even when the required specifications and the design specifications are represented by different notations.

### Solution to Problem

A design verification apparatus according to the present invention inspects whether or not design specifications comply with required specifications by using a logical expression in which symbols correspond to each other between the required specifications and the design specifications.

### Advantageous Effects of Invention

A design verification apparatus according to the present invention can automatically inspect whether or not design specifications comply with required specifications even when the requirement specifications and the design specifications are described by different notations.

### Brief Description of Drawings

FIG. 1 is a configuration diagram of a design verification apparatus 100 according to Embodiment 1.
FIG. 2 illustrates a tree structure showing an example of required specifications described in required specification data 210.
FIG. 3 is a block diagram illustrating an example of design specifications described in design specification data 220.
FIG. 4 illustrates an example in which a behavior of the design specification data 220 is represented by a programming language (C language).
FIG. 5 illustrates a specific example of correspondence data 230.
FIG. 6 is a flowchart for describing an operation of the design verification apparatus 100.
FIG. 7 illustrates an example of a symbol correspondence table generated in step S601.
FIG. 8 is a flowchart for describing details of step S2602.
FIG. 9 illustrates an example in which an output unit 140 displays an inspection result obtained by an inspection unit 130 on a screen.
FIG. 10 illustrates an example in which the design specification data 220 are represented by Promela, which is a description language of a model inspector SPIN (simple Promela interpreter).
FIG. 11 is a system configuration diagram in a case where the design verification apparatus 100 is mounted by using a computer.

### Description of Embodiments

### <Embodiment 1>

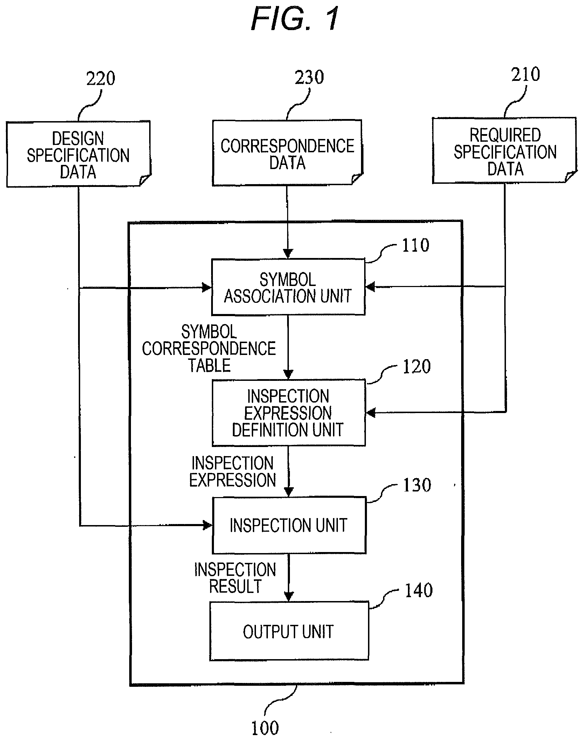

FIG. 1 is a configuration diagram of a design verification apparatus 100 according to Embodiment 1 of the present invention. The design verification apparatus 100 is an apparatus which verifies whether or not design specifications satisfy required specifications. The design verification apparatus 100 receives required specification data 210, design specification data 220, and correspondence data 230 as input data. The design verification apparatus 100 includes a symbol association unit 110, an inspection expression definition unit 120, an inspection unit 130, and an output unit 140.

The required specification data 210 are data describing a set of requirements for a system which is a design target. Each requirement can be represented by a format specification description language by using a symbol such as a propositional variable or the like. The required specification data 210 are represented in a tree form in which a superior requirement branches into inferior requirements. A node of the tree corresponds to each requirement. An example of requirements described in the tree form will be described later.

The design specification data 220 are data describing design specifications of a design target system. Specific example of the design specification data 220 include data describing a system architecture, a software architecture, a hardware specification, a software specification, and the like. The design specification data 220 can be represented by a simulatable programming language, a format specification description language, or the like.

The correspondence data 230 are data describing a logical correspondence between a symbol used in the required specification data 210 and a symbol used in the design specification data 220. Here, the symbol refers to a logical expression used to describe a requirement in each specification, a program variable used in the logical expression, or the like. For example, in each specification, in a case where the same elements are represented by different symbols/different variables or in a case where the same behaviors are differently represented, the correspondence data 230 can describe a correspondence therebetween. A detailed example of the correspondence data 230 will be described later.

The symbol association unit 110 associates the symbol used in the required specification data 210 and the symbol used in the design specification data 220 with each other and outputs the correspondence therebetween as a symbol correspondence table. A detailed example of the symbol correspondence table will be described later.

The inspection expression definition unit 120 defines an inspection expression for inspecting whether or not the design specifications described by the design specification data 220 comply with the required specifications described by the required specification data 210. The inspection expression can be defined as, for example, a logic expression for verifying whether or not logic represented by the inspection expression is valid by being executed while being incorporated as a part of a program. Alternatively, the inspection expression can also be described as a format specification description language. A procedure in which the inspection expression is defined will be described later.

The inspection unit 130 inspects the design specification data 220 by using the inspection expression defined by the inspection expression definition unit 120. When the design specification data 220 are described by a programming language, the inspection is performed by executing simulation of the program. When the design specification data 220 are described by using a format specification description language, the inspection is performed by format verification. The inspection expression definition unit 120 defines an inspection expression according to a description format of the design specification data 220.

The output unit 140 outputs an inspection result obtained by the inspection unit 130. For example, the output unit 140 can output data describing the inspection result or can display the inspection result on a screen. Another appropriate output format can also be used. An example of the output of the inspection result will be described later.

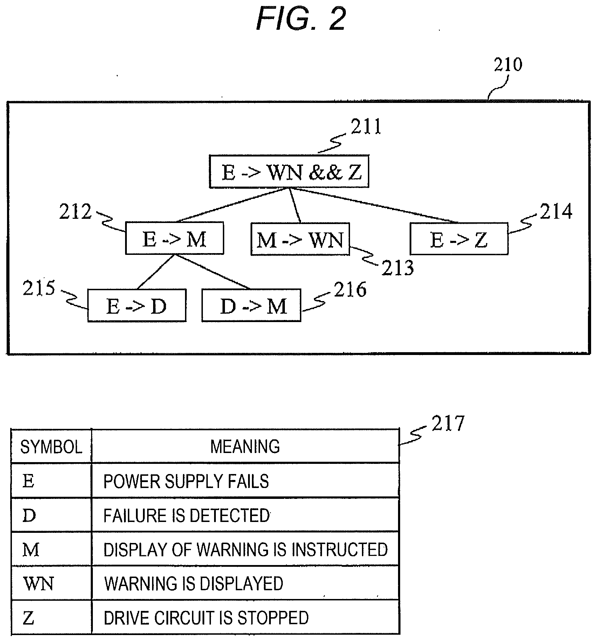

FIG. 2 illustrates a tree structure showing an example of required specifications described in the required specification data 210. The required specification data 210 have a tree structure with the highest level requirement 211 as a root. Requirements 211 to 216 are described in a form of "A→B" by using propositional logic (A and B are propositional variables). A is called antecedent and B is called consequent. This description method is a method simplified by introducing syntactic sugar to a temporal logic formula "A→◇B" (◇ means "sometime"). A logical expression of each requirement may be an expression in which a plurality of propositions logically conjoin through logical disjunction or logical conjunction.

Propositional variables used to describe the requirements 211 to 216 are defined in a symbol dictionary 59. Here, E which means "power supply fails", D which means "failure is detected", M which means "display of warning is instructed", WN which means "warning is displayed", and Z which means "drive circuit is stopped" are used as examples of the propositional variables.

The requirement 211 is described as "E→WN&&Z", which means that "if a power supply fails, warning is displayed and a drive circuit is stopped". The requirement 211 branches into inferior requirements 212 to 214. The requirement 212 is "E→M" (if the power supply fails, display of warning is instructed), the requirement 213 is "M→WN" (if the display of warning is instructed, the warning is displayed), and the requirement 214 is "if the power supply fails, the drive circuit is stopped". The requirement 212 branches into inferior requirements 5215 to 216. The requirement 215 is "E→D" (if the power supply fails, the failure is detected) and the requirement 216 is "D→M" (if the failure is detected, the display of warning is instructed).

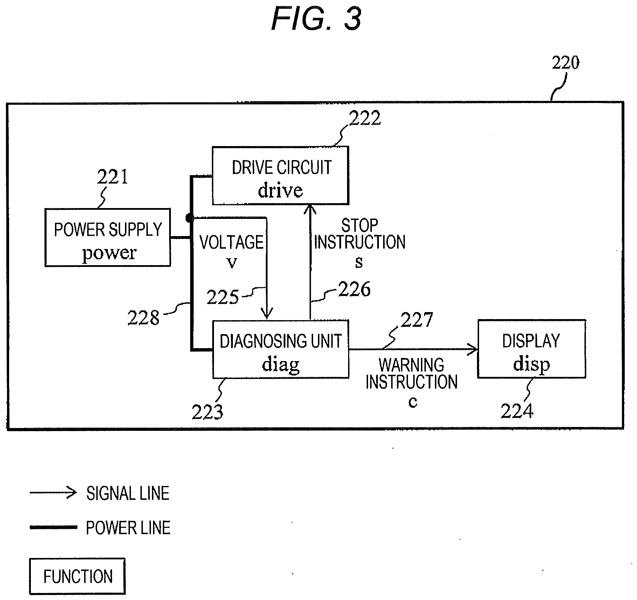

FIG. 3 is a block diagram illustrating an example of design specifications described in the design specification data 220. Functional blocks described in the design specification data 220 include a power supply 221, a drive circuit 222, a diagnosing unit 223, and a display 224. A power line 228 connects the power supply 221 and the drive circuit 222 to each other and connects the power supply 221 and the diagnosing unit 223 to each other. Power supply to the display 224 is omitted for convenience.

A voltage 225 is a signal line for notifying of a voltage of the power line 228. A stop instruction 226 is a signal line for transmitting a stop instruction to the drive circuit 222. A warning instruction 227 is a signal line for transmitting a warning instruction to the display 224. The voltage 225 is represented by a voltage v, the stop instruction 226 is represented by (a presence or absence of) a stop instruction s, and the warning instruction 227 is represented by (a presence or absence of) a warning instruction c. The voltage 225 is connected from the power line 228 to the diagnosing unit 223, the stop instruction 226 is connected from the diagnosing unit 223 to the drive circuit 222, and the warning instruction 227 is connected from the diagnosing unit 223 to the display 224.

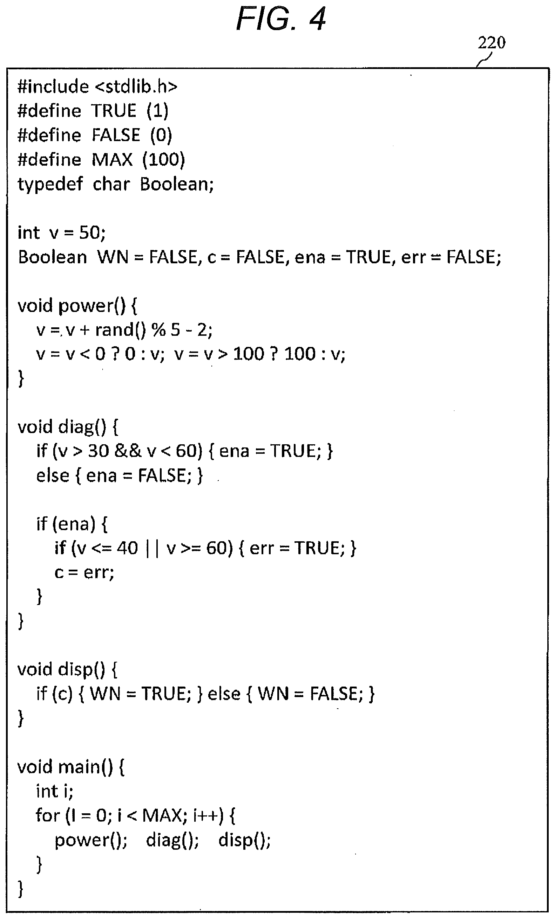

FIG. 4 illustrates an example in which a behavior of the design specification data 220 is represented by a programming language (C language). A program illustrated in FIG. 4 may be included in the design specification data 220, or may be described separately from the design specification data 220. However, an actual content input to the design verification apparatus 100 as the design specification data 220 is described by a programming language or a specification description language which can be inspected by the inspection unit 130 as illustrated in FIG. 4.

The program in FIG. 4 has functions power(), diag(), and disp(). These functions correspond to the power supply 221, the diagnosing unit 223, and the display 224, respectively. A function corresponding to the drive circuit 222 is omitted for convenience. A function main() is a function for executing simulation one time. The voltage v is scaled so as to have a value ten times the value of the actual system.

As for the function power(), the voltage v has a value of 0 to 100, an initial value of the voltage v is 50, and the voltage v is updated so as to be changed within a range of ±2. As for the function diag(), a flag variable ena which indicates whether or not the diagnosing unit 223 is operable is set to TRUE (operable) when the voltage v is larger than 30 and less than 60, and is set to FALSE (not operable) otherwise. When the diagnosing unit 223 is operable and the voltage v is equal to or less than 40, or equal to or more than 60, a flag err which indicates a voltage failure is set to TRUE (the voltage failure occurs). In addition, a flag c which indicates a presence or absence of the warning instruction is set to the same value as the value of err. As for the function disp(), when the warning instruction flag c is TRUE, a flag WN which indicates whether or not the warning is displayed is set to TRUE.

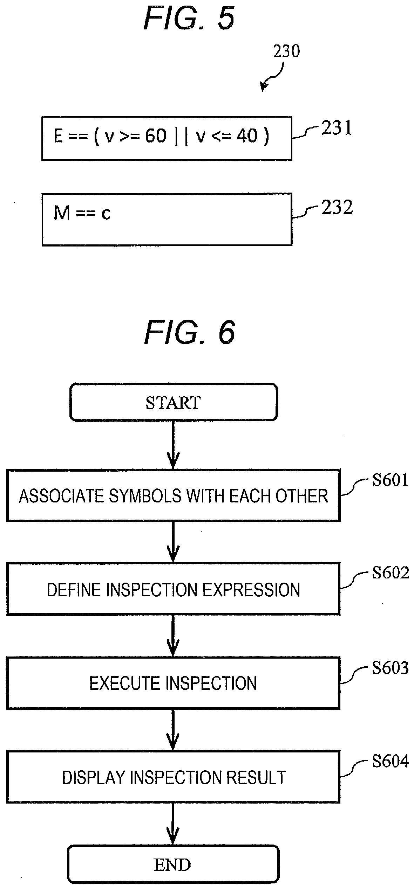

FIG. 5 illustrates a specific example of the correspondence data 230. The correspondence data 230 is described by using the same notation as the notation by which the required specification data 210 are described. In a correspondence 231, a logical expression "E == (v >= 60 || v <= 40)" is defined. That is, the logical proposition represented by the symbol "E" described in the required specification data 210 is equivalent to "the voltage v equal to or more than 60 or the voltage v equal to or less than 40" in the design specification data 220. In a correspondence 232, a logical expression "M == c" is defined. That is, the logical proposition represented by the symbol "M" described in the required specification data 210 is equivalent to the warning instruction c in the design specification data 220.

FIG. 6 is a flowchart for describing an operation of the design verification apparatus 100. The symbol association unit 110 generates a symbol correspondence table (S601). The inspection expression definition unit 120 defines an inspection expression for verifying the design specification data 220 (S602). Details of step S602 will be described later. The inspection unit 130 inspects the design specification data 220 by using the inspection expression defined by the inspection expression definition unit 120 (S603). The output unit 140 outputs an inspection result obtained by the inspection unit 130 (S604).

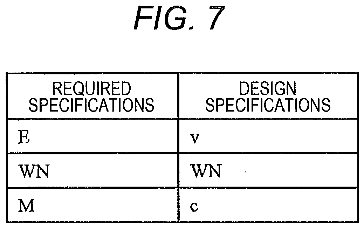

FIG. 7 is an example of the symbol correspondence table generated in step S601. According to the symbol correspondence table illustrated in FIG. 7, the symbols E, WN, and M described in the required specification data 210 are regarded as corresponding to the symbols v, WN, and c described in the design specification data 220, respectively. The first row is generated based on the correspondence 231. The third row is generated based on the correspondence 232.

A method of generating the symbol correspondence table is as follows. The symbol association unit 110 retrieves whether or not each of the symbols included in the respective logical expressions (correspondences 231 and 232 in FIG. 5) of the correspondence data 230 is included in any one of the required specification data 210 and the design specification data 220. When all symbols included in the corresponding logical expression are present in any one of the required specification data 210 and the design specification data 220, a symbol included in the required specification data 210 among the symbols included in the corresponding logical expression is classified as the required specification, a symbol included in the design specification data 220 is classified as the design specification, and these classified symbols are registered as a record of one row of the symbol correspondence table.

In not only a case where a symbol of the required specification data 210 and a symbol of the design specification data 220 correspond one-to-one, but also a case of a one-to-many correspondence (for example, a logical expression is E = v1 + v2), a many-to-one correspondence, or a many-to-many correspondence, the symbol correspondence table can be generated in the same manner. For example, when the logical expression described in the correspondence data 230 is E = v1 + V2, a record in which "E" is described as the required specification and "vl, v2", or the like is described as the design specification may be recorded in the symbol correspondence table. This is because it is only necessary that the fact that symbols corresponding to each other are present between the required specification and the design specifications can be confirmed from the symbol correspondence table as described below.

In addition, also when the same symbols are used in the required specification data 210 and the design specification data 220, the symbol association unit 110 considers that the symbols correspond to each other and registers the correspondence of the symbols in the symbol correspondence table. The second row (WN) in FIG. 7 corresponds to this case.

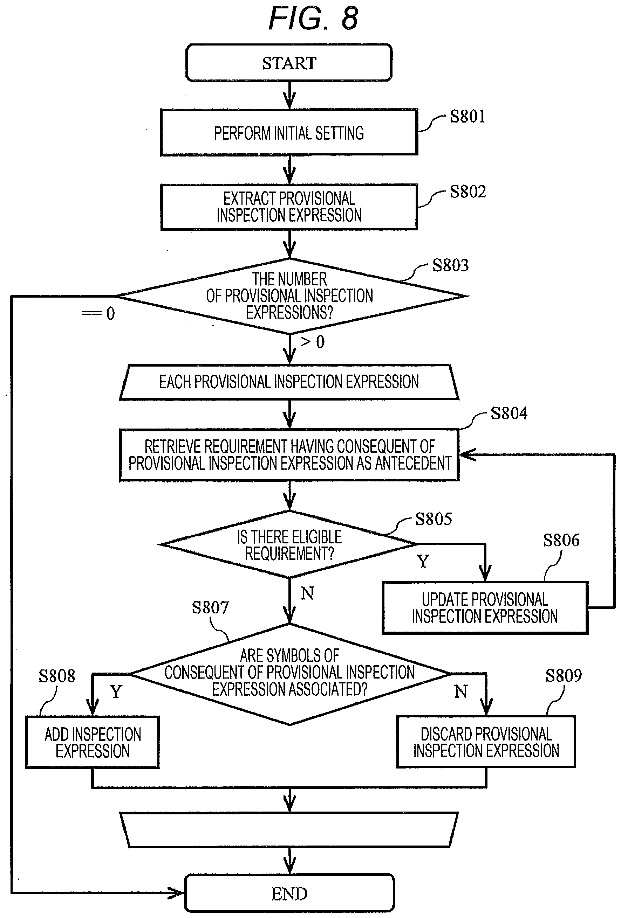

FIG. 8 is a flowchart for describing details of step S602. The inspection expression is defined in a form of "X→Y" (if X, then Y), similarly to the required specifications. X and Y are variables representing propositions. The inspection expression is described by simplifying a temporal logic formula, similarly to the requirement described in the required specification data 210. Hereinafter, an operation of the inspection expression definition unit 120 will be described with reference to FIG. 8.

### (FIG. 8: step S801)

The inspection expression definition unit 120 performs initial setting. In detail, the initial setting corresponds to processing such as initialization of an inspection expression or a provisional inspection expression. The provisional inspection expression is a logical expression which is a candidate of the inspection expression in the following step.

### (FIG. 8: step S802)

The inspection expression definition unit 120 extracts a requirement in which all symbols of an antecedent are registered in the symbol correspondence table among requirements included in the required specification data 210. The inspection expression definition unit 120 temporarily stores a logical expression of the extracted requirement as the provisional inspection expression.

### (FIG. 8: step S802: Supplement)

The design verification apparatus 100 uses a logical expression, in which a correspondence between a symbol described in the required specification data 210 and a symbol described in the design specification data 220 is valid, as the inspection expression. In this step, whether or not a correspondence with respect to the antecedent is valid is checked to thereby narrow down candidates for the inspection expression.

### (FIG. 8: step S803)

The inspection expression definition unit 120 counts the number of provisional inspection expressions. When the number of provisional inspection expressions is larger than 0, steps S804 to S809 are performed with respect to each provisional inspection expression. When the number of provisional inspection expressions is 0, it is regarded that there is no inspection expression and thus this flowchart ends.

### (FIG. 8: steps S804 and S805)

The inspection expression definition unit 120 retrieves one requirement having a consequent of a provisional inspection expression, which is currently dealt with, as an antecedent from the required specification data 210. However, a requirement which is already dealt with in step S802 or step S804 is excluded from a retrieval target. When there is an eligible requirement, the flowchart proceeds to step S806, and when there is no eligible requirement, the flowchart proceeds to step S807.

### (FIG. 8: step S806)

The inspection expression definition unit 120 substitutes a consequent of a provisional inspection expression with a consequence of the requirement retrieved in step S804. For example, when the provisional inspection expression is "X→Y" and the requirement obtained in step S804 is "Y→Z", the provisional inspection expression is updated to "X→Z". As a result, a new logical expression "X→Z" is obtained by conjoining the logical expressions "X→Y" and "Y→Z". The logical expression obtained by the conjoining is used as the inspection expression, such that it is possible to collectively verify the requirements "X→Y" and "Y→Z". A more detailed example will be described later.

### (FIG. 8: step S807)

The inspection expression definition unit 120 checks whether or not all symbols of a consequent of a provisional inspection expression are registered in the symbol correspondence table. When all the symbols of the consequent are registered, the flowchart proceeds to step S808, otherwise, the flowchart proceeds to step S809. In this step, it is possible to extract a logical expression in which symbols of an antecedent and a consequent are associated as the inspection expression.

### (FIG. 8: steps S808 and S809)

The inspection expression definition unit 120 registers a provisional inspection expression which is determined that symbols are associated in step S807 as a formal inspection expression. However, in a case where the provisional inspection expression is already registered, there is no need to register the provisional inspection expression again. The inspection expression definition unit 120 discards a provisional inspection expression which is determined that symbols are not associated in step S807 from the candidates for the inspection expression.

Hereinafter, a procedure in which the inspection expression definition unit 120 extracts the inspection expression from the required specification data 210 in FIG. 2 will be described. For convenience of explanation, it is assumed that only the correspondence 231 in FIG. 5 is given and the correspondence 232 is not given. Therefore, only the first row and the second row in the symbol correspondence table in FIG. 7 are used.

In step S802, the inspection expression definition unit 120 extracts a requirement having the symbol E or WN included in the symbol correspondence table as an antecedent from the required specification data 210. The extracted requirement is regarded as a provisional inspection expression. Here, the requirements 211, 212, 214, and 215 are applicable. The way in which these requirements are dealt with will be described with reference to the flowchart of FIG. 8.

As for the requirement 211, there is no other requirement having a consequent (WN&&Z) of the requirement 211 as an antecedent and thus no requirement is extracted in step S804. As a result, a determination result in step S805 and step S807 is No, such that the requirement 211 is discarded in step S809.

As for the requirement 212, the requirement 213 having a consequent (M) of the requirement 212 as an antecedent is extracted in step S804. Accordingly, it is possible to conjoin logical expressions "E→M" and "M→WN", such that the provisional inspection expression is updated to "E→WN" in step S806. "E→WN" is registered as the inspection expression in step S808.

The requirement 214 is discarded in step S809 similarly to the requirement 211.

As for the requirement 215, the requirement 216 having a consequent (D) of the requirement 215 as an antecedent is extracted in step S804. Therefore, the provisional inspection expression is updated to "E→M" in step S806. In addition, the requirement 213 having a consequent (M) of the updated provisional inspection expression as an antecedent is extracted, and thus the provisional inspection expression becomes "E→WN". However, since this provisional inspection expression is already registered, this provision inspection expression is not registered in step S808.

When the correspondence 232 is further given, the requirement 213 having the symbol M included in the symbol correspondence table as an antecedent is extracted as the provisional inspection expression. In this case, the final inspection expression becomes "E→M" and "M→WN".

Hereinafter, a method in which the inspection unit 130 inspects the design specification data 220 will be described. The inspection unit 130 rewrites the inspection expression by using the symbol correspondence table before executing an inspection. "E→WN" is rewritten as "(v <= 40 || v >= 60)→WN". The inspection unit 130 compiles the design specification data 220 to simulate a behavior of the design specification data 220 and repeatedly executes the inspection by a predetermined number of times. The inspection unit 130 determines whether or not the inspection expression is valid, each time the inspection is executed. If there is a case in which an antecedent (v <= 40 || v >= 60) is true but a consequent (WN) is false even once, it is determined that the inspection expression "E→WN" is inappropriate. If an antecedent (E) never becomes true during the simulation, an inspection result becomes "unconfirmable". When the simulation is completed in a state where the inspection expression is determined as neither inappropriate nor unconfirmable, the inspection expression is determined as appropriate.

The design specification data 220 illustrated in FIG. 4 are described so that err = TRUE when the voltage v is 60, therefore, in principle, it is to be regarded that a voltage failure occurs. On the other hand, when the voltage v is 60, ena = FALSE, such that the expression "err = TRUE" is not executed. As a result, the expression "c = FALSE" is maintained and WN = FALSE. In this case, even if the requirement E (v <= 40 || v >= 60) is TRUE when the voltage v is 60, WN = FALSE. Accordingly, the inspection expression is not valid. In other words, the inspection expression "E→WN" is determined as inappropriate. The output unit 140 outputs a condition (here, voltage v = 60) which is not satisfied by the inspection expression, together with the inspection result. Whether or not the inspection expression is valid is verified also for other values of the voltage v.

The inspection unit 130 inspects the design specification data 220, such that it is possible to automatically inspect consistency (a presence or absence of contradiction) between the required specification data 210 and the design specification data 220. In addition, the same objects/behaviors are expressed by different symbols between the required specification data 210 and the design specification data 220. However, even in this case, it is possible to automatically associate the symbols of the required specification data 210 and the symbols of the design specification data 220 to each other, generate a confirmable inspection expression, and execute the inspection.

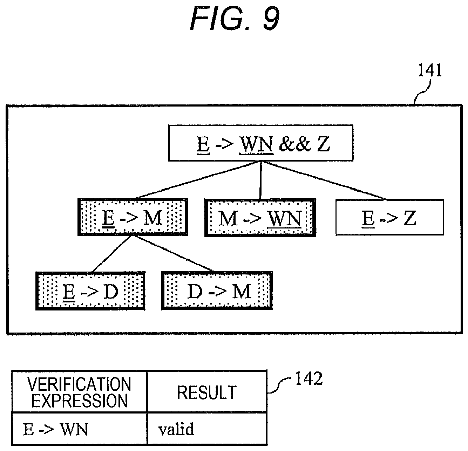

FIG. 9 illustrates an example in which the output unit 140 displays the inspection result obtained by the inspection unit 130 on the screen. Here, an example in which the required specification data 210 described in FIG. 2 are inspected as an input, and the inspection expression "E→WN" is satisfied is illustrated (inspection expression section 142).

In a required specification section 141, an inspection result is reflected to a tree structure of the required specification data 210. Symbols described in the symbol correspondence table are underlined. Requirements (the requirements 212 and 213 in the example described above) used when generating the satisfied inspection expression are each surrounded by a bold line. In addition, as the inspection expression is satisfied, it can be considered that inferior requirements (the requirements 215 and 216) of the requirements are also regarded as being indirectly satisfied. Therefore, the inferior requirements are also each surrounded by a bold line. A requirement of which all inferior requirements are satisfied may be displayed as being satisfied. For example, when the requirement 215 and the requirement 216 are regarded as the inspection expression and are satisfied, the requirement 212 may be displayed as being satisfied.

In the required specification section 141, it is possible to present a range of requirements of the required specification data 210 satisfied by the design specification data 220 and to present a range of requirements which are not inspected, the required specification data 210 having the tree form in which a superior requirement branches into inferior requirements. As a result, a user can efficiently confirm/review the required specification data 210 or the design specification data 220. For example, the user can modify the required specification data 210 or the design specification data 220 for a requirement which is not satisfied. In addition, a requirement irrelevant to the inspection expression (in other words, a requirement which is not inspected) can be inspected by supplement the correspondence data 230 as necessary.

### <Embodiment 2>

Although the requirement or the inspection expression is described by using propositional logic in Embodiment 1, the requirement or the inspection expression may be described by using a temporal logic formula, instead of the propositional logic. When a requirement is described by using the temporal logic formula, a procedure of processing of the inspection expression definition unit 120 described in FIG. 8 is slightly changed. For example, in a case where linear temporal logic (LTL) is used as the temporal logic and a requirement is described in a form of, for example, "X→◇Y", "X→◇Y" and "Y→◇Z" logically conjoin in step S804 and a provisional inspection expression is updated to "X→◇Z" in step S806. When the correspondence 231 is given and the correspondence 232 is not given, an inspection expression registered in step S808 becomes "E→◇WN". In addition, the inspection expression definition unit 120 uses □ (always) to enclose the inspection expression obtained by the flowchart of FIG. 8 and the final inspection expression becomes "□(E→◇WN)".

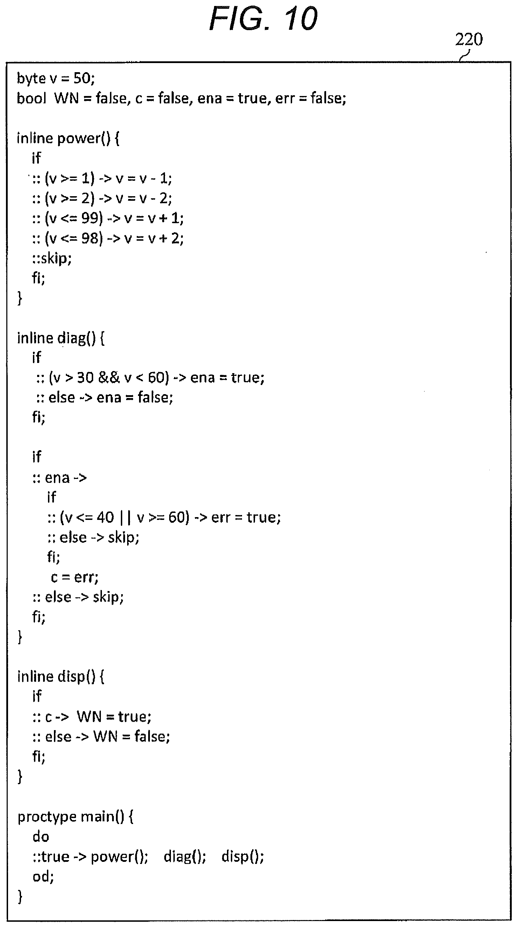

FIG. 10 illustrates an example in which the design specification data 220 are represented by Promela which is a description language of a model inspector SPIN (simple Promela interpreter). Here, an example in which the same behavior as that in FIG. 4 is described is illustrated. A model inspection which is one of format inspections can be performed more strictly in comparison to the simulation.

The inspection unit 130 combines the design specification data 220 and the inspection expression "□(E→◇WN)" by the temporal logic and inputs them to the model inspector SPIN to generate an executable inspector, thereby executing the inspection. The model inspector outputs whether or not the inspection expression is appropriate and an execution path violating the inspection expression as a counterexample when the inspection expression is not satisfied. As for the design specification data 220 illustrated in FIG. 10, a case where even when the voltage v is equal to or more than 60, WN is not true can be obtained as a counterexample. Therefore, the inspection result is that the inspection expression is inappropriate. The output unit 140 outputs an inspection expression and an inspection result, and a counterexample, similarly to FIG. 9.

### <Embodiment 3>

Each functional unit (symbol association unit 110 to output unit 140) of the design verification apparatus 100 described in Embodiments 1 and 2 can be installed as software. The design verification apparatus 100 can be configured by using a computer including a processor which executes each functional unit, a display screen, a main operational device, a main storage device (main memory), a storage medium (a hard disk or the like), and an input device (a keyboard, a pointing device, or the like).

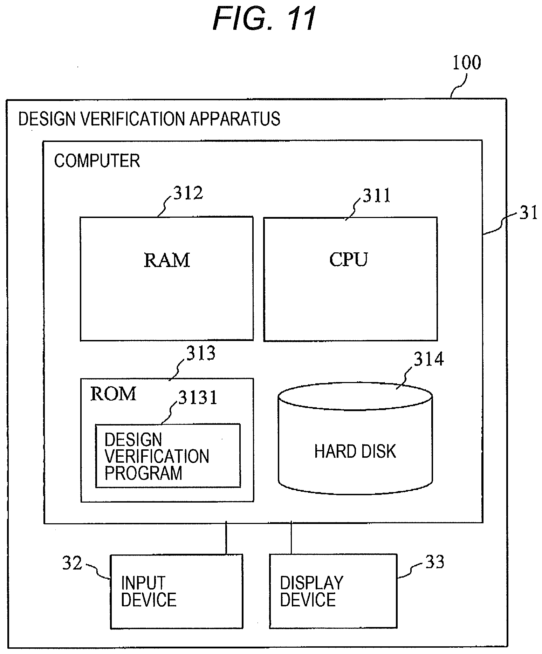

FIG. 11 is a system configuration diagram in a case where the design verification apparatus 100 is mounted by using a computer. The symbol association unit 110 to the output unit 140 are installed as a design verification program 3131. The design verification program 3131 is stored in, for example, a read only memory (ROM) 313 of a computer 21, is read by a central processing unit (CPU) 311, and is executed with a random access memory (RAM) 312 as a temporary storage region. The computer 21 executes processing defined by the design verification program 3131. Respective input data (the required specification data 210 to the correspondence data 230), output data from the inspection unit 130, and electronic data such as an intermediate processing result are stored in a hard disk 314 of the computer 31. A user operation such as an inspection execution instruction can be performed through an input device 22.

An output from the output unit 140 is performed with respect to, for example, a display device 33 such as a display, or the hard disk 314, but is not limited thereto. For example, the output unit 140 may use an output form such as an output to an external computer (not illustrated) through a network, an output in a data file form to an external storage medium such as a CD-ROM, or the like.

### <As For Modified Example of Present Invention>

The present invention is not limited to the embodiments described above, but includes various modified examples. For example, the embodiments described above have been described in detail in order to facilitate understanding of the present invention, and are not necessarily limited to including all the configurations described above. In addition, a part of the configuration of one embodiment can be replaced by the configuration of another embodiment or the configuration of another embodiment can be added to the configuration of one embodiment. Further, it is possible to add, delete, and replace other configurations with respect to a part of the configuration of each embodiment.

The embodiments described above have described that when the same symbols are used in the required specification data 210 and the design specification data 220, these symbols are regarded as corresponding to each other. However, whether or not these symbols have a correspondence may be selected by a designer or a user of the design verification apparatus 100.

In the embodiments described above, the required specification section 141 may use an appropriate display form of the inspection result, other than that illustrated in FIG. 9. For example, requirements (the requirements 212, 213, 215, and 216 in the described example) related to generation of an inspection expression may be marked with a sign (e.g., a check mark) indicating that the inspection expression is satisfied and a sign (e.g., × mark) indicating that the inspection expression is not satisfied. A requirement which is not related to all inspection expressions may be marked with a sign (e.g., question mark) indicating that the requirement is not related to all inspection expressions.

In the embodiments described above, the correspondence data 230 can be given by, for example, a designer of the required specification data 210 or the design specification data 220, or if the correspondence data 230 can be automatically generated by comparing the required specification data 210 and the design specification data 220 with each other by appropriate means, the correspondence data 230 can be given by being automatically generated.

### Reference Signs List

- 100: design verification apparatus
- 110: symbol association unit
- 120: inspection expression definition unit
- 130: inspection unit
- 140: output unit
- 210: required specification data
- 220: design specification data
- 230: correspondence data

## Claims

1. A design verification apparatus for verifying consistency between required specifications described by logically conjoining specification requirements represented by using a specification description language and design specifications obtained by designing the required specifications as software, the design verification apparatus comprising:
a symbol association unit which generates a symbol correspondence table in which correspondences between symbols used in the required specifications and symbols used in the design specifications are described;
an inspection expression definition unit which extracts a specification requirement including a symbol described in the symbol correspondence table among the specification requirements as an inspection expression for inspecting whether or not the design specifications satisfy the required specifications; and
an inspection unit which inspects whether or not the design specifications satisfy the required specifications by using the inspection expression.

2. The design verification apparatus according to claim 1, wherein
the required specifications describe a first requirement having a first antecedent and a first consequent, and a second requirement having a second antecedent and a second consequent as the specification requirements, and
when the first consequent and the second antecedent are represented by the same logical expression, the inspection expression definition unit extracts a conjoining logical expression having the first antecedent as an antecedent and the second consequent as a consequent, as the inspection expression.

3. The design verification apparatus according to claim 2, wherein the inspection expression definition unit extracts a conjoining logical expression of which the first antecedent and the second consequent are described in the symbol correspondence table, as the inspection expression.

4. The design verification apparatus according to claim 3, wherein the inspection unit collectively inspects the first requirement and the second requirement by using the conjoining logical expression as the inspection expression.

5. The design verification apparatus according to claim 1, wherein
the symbol association unit receives correspondence data describing a correspondence between a logical expression described in the required specifications and a logical expression described in the design specifications, and
the symbol association unit generates the symbol correspondence table by extracting the correspondences between the symbols used in the required specifications and the symbols used in the design specification from the correspondence described in the correspondence data.

6. The design verification apparatus according to claim 1, wherein the required specifications are described with a logical structure in a tree form in which a logical expression expressed by an antecedent and a consequent is divided into a plurality of different logical expressions, each of which is expressed by an antecedent and a consequent.

7. The design verification apparatus according to claim 1, wherein the inspection unit inspects whether or not the design specifications satisfy the required specifications by verifying whether or not a phenomenon represented by the inspection expression is valid in an execution process by executing a program in which the inspection expression is incorporated, or by performing format verification of whether or not the inspection expression is logically valid.

8. The design verification apparatus according to claim 1, further comprising an output unit which outputs an inspection result obtained by the inspection unit.

9. The design verification apparatus according to claim 8, wherein the output unit outputs a fact that a symbol among the symbols used in the required specifications is described in the symbol correspondence table, together with the inspection result.

10. The design verification apparatus according to claim 4, further comprising:
an output unit which outputs an inspection result obtained by the inspection unit,
wherein the output unit outputs the fact that the first requirement and the second requirement are collectively inspected by using the conjoining logical expression as the inspection expression, as the inspection result.
